# EUROPÄISCHE PATENTSCHRIFT

(11) **EP 2 217 526 B1**
(45) Veröffentlichungstag und Bekanntmachung des Hinweises auf die Patenterteilung: **18.05.2011**
(21) Anmeldenummer: 08847264.2
(22) Anmeldetag: 13.10.2008
(51) Int. Cl.: B81C 1/00

(54) **VERFAHREN ZUR HERSTELLUNG VON MIKROMECHANISCHEN STRUKTUREN MIT RELIEFARTIGEM SEITENWANDVERLAUF ODER EINSTELLBAREM NEIGUNGSWINKEL**
METHOD FOR PRODUCING MICROMECHANICAL STRUCTURES HAVING A PROTRUDING LATERAL WALL PROGRESSION OR AN ADJUSTABLE ANGLE OF INCLINATION
PROCÉDÉ POUR PRODUIRE DES STRUCTURES MICROMÉCANIQUES COMPORTANT DES PAROIS LATÉRALES EN RELIEF ET UN ANGLE D'INCLINAISON VARIABLE

(30) Priorität: 05.11.2007 DE 102007052661
(43) Veröffentlichungstag der Anmeldung: 18.08.2010
(73) Patentinhaber: Robert Bosch GmbH, 70442 Stuttgart (DE)
(72) Erfinder: LAERMER, Franz, 71263 Weil Der Stadt (DE); FUCHS, Tino, 72076 Tuebingen (DE); LEINENBACH, Christina, 66806 Ensdorf (DE)
(86) Internationale Anmeldenummer: PCT/EP2008/063703
(87) Internationale Veröffentlichungsnummer: WO 2009/059868

(56) Entgegenhaltungen:
- US-A1- 2007 098 344
- CHRISTINA LEINENBACH ET AL: "A novel sacrificial layer technology based on highly selective etching of silicon-germanium in CLF3" MICRO ELECTRO MECHANICAL SYSTEMS, 2007. MEMS. IEEE 20TH INTERNATIONAL CONFERENCE ON, IEEE, PI, 1. Januar 2007 (2007-01-01), Seiten 65-68, XP031203768 ISBN: 978-1-4244-0950-1
- SOULIMANE S ET AL: "Polymeric material sacrificial layer for MEMS fabrication" NANOFUN-POLY INTERNATIONAL CONFERENCE, XX, XX, 29. Mai 2006 (2006-05-29), XP002432492

## Beschreibung

### Stand der Technik

Die vorliegende Erfindung betrifft ein Verfahren zur Herstellung von mikromechanischen Strukturen mit reliefartigem Seitenwandverlauf oder einstellbarem Neigungswinkel auf einem Silizium-Halbleitersubstrat.

Bei der Herstellung mikromechanischer Strukturen oder Bauteile dient zumeist Silizium aufgrund der für diese Anwendung hervorragenden Eigenschaften als funktionelle Schicht. Diese funktionelle Siliziumschicht kann durch weitere Schichten ergänzt werden, beispielsweise Oxid- oder Nitridschichten, wobei ein Aufbau von Schichtpaketen resultieren kann. Eine selektive Entfernung einer bestimmten Schicht, beispielsweise einer so genannten Opferschicht, auf einem Silizium-Halbleitersubstrat ist eine bekannte Maßnahme bei Herstellungsverfahren von Halbleiterbauelementen, insbesondere bei Verfahren zur Herstellung von freitragenden Strukturen. Beispielsweise wird bei der Herstellung mikromechanischer Sensoren eine Opferschicht auf einem Halbleitersubstrat ausgebildet, auf die weitere Strukturschichten abgeschieden und strukturiert werden. Anschließend wird diese Opferschicht zur Freilegung der weiteren Strukturen selektiv entfernt. Häufig verwendete Opferschichten sind Silizium-Germanium (SiGe)-Mischhalbleiterschichten, da Silizium-Germaniumschichten gegenüber Siliziumschichten selektiv entfernbar sind. Durch kontrolliertes Entfernen der Opferschicht aus SiGe wird eine darüber angeordnete freitragende Struktur erzeugt.

Bei der Verwendung von SiGe-Schichten wird gegebenenfalls im weiteren Verfahren eine Ausbildung einer Diffusionsbarriere zu benachbarten, auf Silizium basierenden Schichten erforderlich, da bei Überschreiten entsprechender Aktivierungsenergien, beispielsweise bei Hochtemperatur- oder Temperprozessen der weiteren Sensorherstellung, Germanium in benachbarte Silizium-Schichten diffundieren würde. Geeignete Diffusionsbarrieren sind beispielsweise Siliziumoxid-Schichten.

Neben einer Freilegung mikromechanischer Strukturen, beispielsweise Sensorstrukturen, mittels einer Opferschichtätzung von SiGe-Schichten ist ebenfalls die Strukturierung von auf Silizium basierenden Schichtanordnungen in der Systemtechnik unabdingbar, vor allem zur Herstellung mikromechanischer Strukturen. So ist es neben einer vollständigen Entfernung einer Opferschicht regelmäßig notwendig, mikromechanische Strukturen herzustellen, die definierte Seitenwandprofile aufweisen, vornehmlich vertikale Seitenwandprofile oder konische Seitenwandprofile.

Entsprechende Seitenwandprofile werden regelmäßig mit einem in der Schrift DE 4241045 C1 beschriebenen Fluor-basierten Silizium-Tiefenätzverfahren hergestellt. Hierbei werden die Seitenwände beispielsweise von herzustellenden Sensorstrukturen mit einem teflonartigen Polymer als Passiviermittel und einem fluorhaltigen Ätzmittel durch komplementäre Ätz- und Passivierschritte erzeugt. Anisotrope Plasmaätzverfahren sind jedoch sehr aufwendig. Weiterhin reichen derart aufgebrachte teflonartige Schutzschichten auf den Seitenwänden der Strukturen oft nicht aus, um einen Ätzangriff während des Plasmaätzschrittes zu vermeiden.

Aus der US 2007/0098344 A1 ist ein Verfahren zur Ausbildung einer Aushöhlung in einer Isolatorschicht bekannt. Hierbei wird zunächst eine Öffnung durch ein anisotropisches Trockenätzen in einer dotierten Schicht und in einer darüberliegenden undotierten Schicht eingebracht. In einem zweiten anschließenden Ätzschritt mit Stickstofftetrafluorid oder Schwefelhexafluorid erfolgt ein Ätzen der dotierten Schicht. Zur Dotierung wird insbesondere Phosphor verwendet. Mit der Phosphordotierung wird der Ätzvorgang somit beeinflusst.

### Offenbarung der Erfindung

Das erfindungsgemäße Verfahren zur Herstellung von mikromechanischen Strukturen mit reliefartigem Seitenwandverlauf oder einstellbarem Neigungswinkel hat den Vorteil, dass neue, plasmalose, anisotrope Strukturierungsmöglichkeiten für mikromechanische Strukturen zur Verfügung gestellt werden können.

Dies wird erfindungsgemäß dadurch erreicht, dass man die mikromechanischen Strukturen aus einer auf einem Silizium-Halbleitersubstrat vorhandenen oder abgeschiedenen SiGe-Mischhalbleiterschicht durch trockenchemisches Ätzen der SiGe-Mischhalbleiterschicht herausätzt, wobei man den Seitenwandverlauf der mikromechanischen Struktur durch Variieren des Germaniumanteils in der zu ätzenden SiGe-Mischhalbleiterschicht ausbildet, wobei in stärker zu ätzenden Bereichen ein höherer Germaniumanteil vorliegt, wobei man die Variation des Germaniumanteils in der SiGe-Mischhalbleiterschicht durch ein Verfahren ausgewählt aus der Gruppe umfassend Abscheiden einer-SiGe-Mischhalbleiterschicht mit variierendem Germaniumgehalt, Einbringen von Germanium in eine Silizium-Halbleiterschicht oder SiGe-Mischhalbleiterschicht, Einbringen von Silizium in eine Germaniumschicht oder SiGe-Mischhalbleiterschicht und/oder durch thermische Oxidation einer SiGe-Mischhalbleiterschicht einstellt.

Insbesondere ermöglicht das erfindungsgemäße Verfahren, über eine Variation der Germaniumkonzentration in SiGe-Mischhalbleiterschichten Strukturierungen vorzunehmen, die gezielt einstellbare konische Seitenwandverläufe aufweisen. Von Vorteil ist hierbei weiterhin, dass die Herstellung konischer Seitenwandverläufe ohne den üblichen erheblichen prozesstechnischen Aufwand, wie Temperaturänderungen, aufwendige Variationen von Passivier- und Ätzzyklen im Strukturierungsprozess und hohe Passiviergasmengen ermöglicht wird.

Eine bevorzugte Variation des Germaniumanteils ist das Ausbilden eines Konzentrationsgradienten. Eine Variation des Germaniumanteils oder ein Konzentrationsgradient von Germanium in einer SiGe-Mischhalbleiterschicht kann sich vorteilhafter Weise direkt auf die Ätzrate im trockenchemischen Ätzen auswirken, ohne dass die Ätzparameter im Verfahren verändert werden müssen. So erfolgt in Bereichen erhöhter Germaniumkonzentration in der Schicht ein stärkerer Abtrag der SiGe-Mischhalbleiterschicht als in Bereichen niedrigerer Germaniumkonzentration, wodurch beispielsweise ein reliefartiger oder ein konischer Seitenwandverlauf ausbildbar ist.

Nach dem trockenchemischen Ätzvorgang können weitere zur Herstellung eines mikromechanischen Bauteils vorgesehene Temperaturprofile oder Temperprozesse gefahren werden, die den Konzentrationsgradienten aufheben können. Hierdurch wird das hergestellte Seitenwandprofil der SiGe-Mischhalbleiterschicht nicht mehr geändert.

Von großem Vorteil ist, dass der Neigungswinkel des konischen Seitenwandverlaufs über die Wahl der Zusammensetzung der SiGe-Mischhalbleiterschicht beliebig einstellbar ist.

Von Vorteil ist hierbei weiterhin, dass in einem Ätzschritt die Herstellung unterschiedlicher Flankenwinkel dadurch ermöglicht wird, dass Bereiche der SiGe-Mischhalbleiterschicht unterschiedliche Germaniumkonzentrationen aufweisen können. Mikromechanische Strukturen mit reliefartiger oder einstellbarem Neigungswinkel, insbesondere einstellbarem konischen Seitenwandverlauf, eignen sich weiterhin insbesondere als Opferschicht, auf die weitere Schichtsysteme abgeschieden werden können, auf die sich der in der SiGe-Mischhalbleiterschicht eingestellte konische Seitenwandverlauf überträgt. Dies ermöglicht beispielsweise eine Anwendung bei der Herstellung von Membranen ohne ebene Einspannung. Weiterhin erlaubt ein konischer Seitenwandverlauf in vorteilhafter Weise die Abscheidung von Schichten, bei denen es wegen einer verhältnismäßig schlechten Konformität Probleme bei vertikal zu beschichtenden Stufen geben kann, beispielsweise bei PECVD-Prozessen, Sputterprozessen oder bei besonders dünnen Schichten.

### Ausführungsbeispiel

### Zeichnungen

Ausführungsbeispiele der Erfindung sind in den Zeichnungen dargestellt und werden in der nachfolgenden Beschreibung näher erläutert. Hierbei zeigt:
- Figur 1a bis 1c: schematische Querschnittansichten der wesentlichen Herstellungsschritte von mikromechanischen Strukturen mit konischem Seitenwandverlauf gemäß einer ersten Ausführungsform der vorliegenden Erfindung.
- Figur 2a bis 2d: schematische Querschnittansichten der wesentlichen Herstellungsschritte mikromechanischer Strukturen gemäß einer zweiten Ausführungsform der vorliegenden Erfindung.

In den Figuren bezeichnen gleiche Bezugszeichen gleiche oder funktionsgleiche Komponenten.

### Beschreibung der Ausführungsbeispiele

Das erfindungsgemäße Verfahren wird zunächst beispielhaft beschrieben.

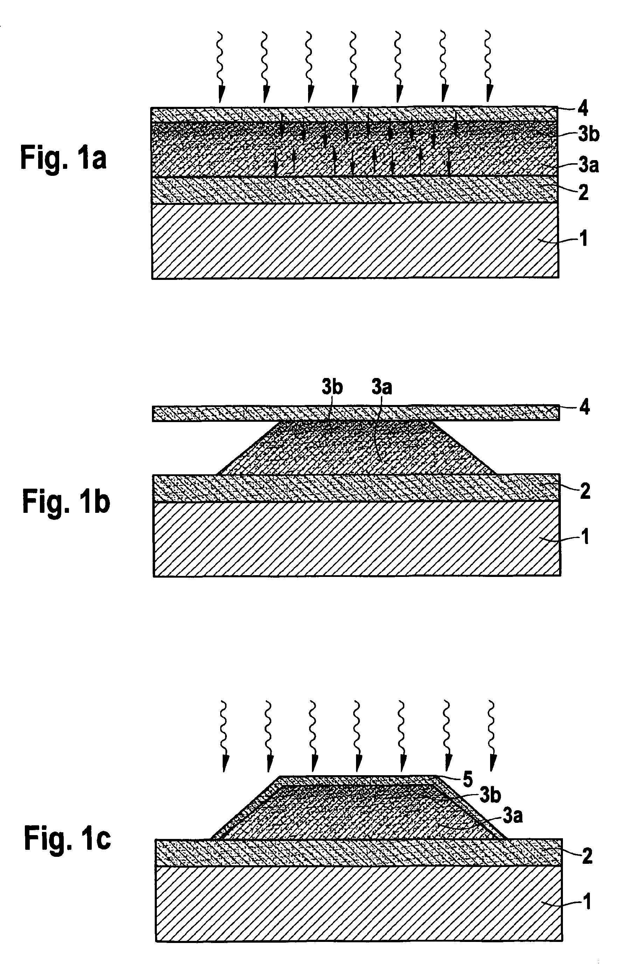

In den Figuren 1a bis 1c ist ein mögliches Herstellungsverfahren mikromechanischer Strukturen mit konischem Seitenwandverlauf dargestellt. Zur Herstellung des in der Figur 1 a gezeigten Schichtsystems wurde auf ein Siliziumsubstrat 1 zunächst eine erste Schicht eines Dielektrikums 2 abgeschieden. Das Dielektrikum 2 kann ein übliches thermisches Isolationsoxid sein, beispielsweise Siliziumdioxid, Siliziumnitrid, verschiedene Gläser oder andere keramische Schichten. Ein bevorzugtes Dielektrikum 2 ist Siliziumdioxid. Für das Abscheiden dieser Schicht können aus der Halbleitertechnik bekannte Abscheideprozesse verwendet werden. Eine mögliche Schichtdicke eines Dielektrikums 2 kann im Bereich von einigen wenigen Mikrometern liegen, und beispielsweise 2,5µm betragen. In diesem Ausführungsbeispiel lag das Silizium als Siliziumsubstrat vor, jedoch kann vorgesehen sein, dass Silizium als Schicht auf einem Substrat vorliegt. Üblicherweise ist das Substrat während des Verfahrens in einer üblichen Prozesskammer positioniert.

Auf die Schicht des Dielektrikums 2 wurde eine SiGe-Mischhalbleiterschicht, bevorzugter Weise eine Poly-SiGe-Mischhalbleiterschicht aufgebracht. Geeignet sind sowohl polykristalline als auch einkristalline SiGe-Mischhalbleiterschichten, wobei eine poly-SiGe-Schicht bevorzugt ist. Die Dicke der SiGe-Mischhalbleiterschicht liegt vorzugsweise im Bereich von 0,5 µm bis 5µm. Beispielsweise kann die Dicke einer abgeschiedenen SiGe-Mischhalbleiterschicht 1,5µm betragen. Der Anteil von Germanium in einer Si₁₋ₓGeₓ-Mischhalbleiterschicht kann je nach Bedarf variieren, ein möglicher Wertebereich für x liegt beispielsweise im Bereich von ≥ 0,01 bis ≤ 0,5, bevorzugt im Bereich von ≥ 0,1 bis ≤ 0,3. Es ist sehr bevorzugt, dass der Gehalt an Germanium einen Wert x < 0,5 aufweist, da dies während einer nachfolgenden thermischen Oxidation zu einem qualitativ hochwertigen möglichst reinen SiO₂ führen kann.

In einem nachfolgenden Verfahrensschritt erfolgte die Ausbildung eines Konzentrationsgradienten von Germanium in der SiGe-Mischhalbleiterschicht durch thermische Oxidation. Durch thermische Oxidation, in den Figuren dargestellt durch wellenförmige Pfeile, bildete sich an der Oberfläche der SiGe-Mischhalbleiterschicht eine Schicht eines thermischen Oxids 4, vorzugsweise eines reinen Siliziumoxids. Das während des thermischen Oxidationsprozesses nicht in das gebildete Siliziumoxid eingebaute Germanium wird in die unter dem Oxid liegende SiGe-Mischhalbleiterschicht eingebunden. Durch diese Ausscheidung des Germaniums aus dem gebildeten Oxid in die darunter liegende SiGe-Mischhalbleiterschicht wurde ein Konzentrationsgradient in dieser Schicht ausgebildet. Vorzugsweise wird die thermische Oxidation bei Temperaturen ausgeführt, die hoch genug sind, um eine Diffusion des Germaniums zu aktivieren, die das Germanium möglichst tief in die SiGe-Mischhalbleiterschicht hinein diffundieren lässt. Vorzugsweise liegen die Temperaturen für die thermische Oxidation der SiGe-Mischhalbleiterschicht in einem Bereich von ≥ 800°C bis ≤ 1300°C. Besonders bevorzugt wird die thermische Oxidation bei einer Temperatur von etwa 1100°C durchgeführt.

Durch die Diffusion des Germaniums während der thermischen Oxidation bildet sich ein erhöhter Germaniumanteil in einem oberen Bereich der SiGe-Mischhalbleiterschicht 3b aus, die an der Grenzfläche zum ausgebildeten thermischen Oxid 4 liegt aus. Darunter liegende Bereiche der SiGe-Mischhalbleiterschicht 3a weisen abhängig von der Diffusion des Germaniums einen geringeren Germaniumanteil auf. Der somit ausgebildete Konzentrationsgradient des Germaniums in der SiGe-Mischhalbleiterschicht wirkt sich vorteilhafter Weise direkt auf die Ätzrate des trockenchemischen Ätzens mit Ätzmitteln wie ClF₃ aus, ohne dass die Ätzparameter im Verfahren verändert werden müssen. Die Ätzrate von SiGe steigt mit zunehmendem Germaniumanteil in der Schicht an, so dass im oberen Schichtbereich 3b ein stärkerer Abtrag der SiGe-Schicht erfolgte als im unterem Bereich 3a, wodurch ein konischer Seitenwandverlauf ausgebildet werden kann, wie in Figur 1b dargestellt ist.

Ein bevorzugtes Ätzgas ist ClF₃. Erfindungsgemäß wurde, wie in der Figur 1b dargestellt ist, durch ein trockenchemisches, plasmaloses Ätzen der SiGe-Schicht mit einem Ätzgas eine hochselektive Ätzung der SiGe-Schicht bewirkt. Bei Verwendung von ClF₃ als Ätzgas zum Ätzen einer SiGe-Schicht beträgt die Selektivität gegenüber einer reinen Siliziumsubstratschicht etwa 4000:1 bis 10000:1, gegenüber dem thermischen Oxid beträgt die Selektivität sogar etwa 100000:1. Somit werden durch den trockenchemischen Ätzvorgang weder das Siliziumsubstrat 1 noch das thermische Oxid 4 durch das Ätzen entfernt.

Nach dem trockenchemischen Ätzen kann die Schicht des thermischen Oxids 4 entfernt werden. Wie in Figur 1c dargestellt, kann die SiGe-Mischhalbleiterschicht mit konischem Seitenwandverlauf einer weiteren thermischen Oxidation unterworfen werden. Während dieser zweiten thermischen Oxidation wurde auf der SiGe-Mischhalbleiterschicht eine Schicht eines thermischen Siliziumoxids 5 abgeschieden. Es kann auf der strukturierten Oberfläche der SiGe-Mischhalbleiterschicht beispielsweise auch eine Belegung mit einem Dielektrikum erfolgen. Von Vorteil ist hierbei, dass die thermische Oxidation allseitig stattfindet und somit die Gefahr einer nicht konformen Schichtabscheidung vermieden werden kann. Es können auch weitere Schichtsysteme abgeschieden werden, in die sich der in der SiGe-Mischhalbleiterschicht eingestellte konische Seitenwandverlauf überträgt. Die SiGe-Mischhalbleiterschicht mit konischem Seitenwandverlauf kann beispielsweise nach der mikromechanischen Strukturierung die Grundlage für eine nachfolgende Abscheidung von Membranschichten mit abgeflachtem Einspannwinkel bilden.

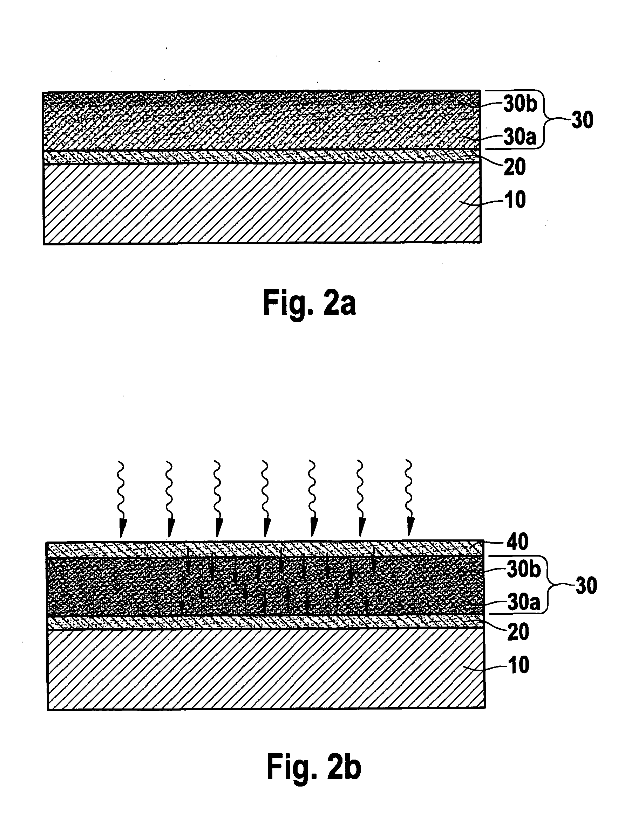

Gemäß einem zweiten Ausführungsbeispiel der vorliegenden Erfindung kann das erfindungsgemäße Verfahren verwendet werden, um mikromechanische Strukturen in einem Mehrschichtsystem zu erzeugen, wie anhand der Figuren 2a bis 2d dargestellt ist. Die Erzeugung entsprechender mikromechanischer Strukturen ist insbesondere im Falle der Herstellung eines symmetrischen Dreischichtsystems von Vorteil. Ist ein Germaniumkonzentrationsgradient in einer Si-Ge-Halbleiterschicht im späteren Verfahren oder Schichtaufbau nicht erwünscht, besteht aber gleichzeitig die Notwendigkeit einer thermischen Oxidation dieser SiGe-Mischhalbleiterschicht, kann ein vorhandener Konzentrationsgradient, beispielsweise durch eine Abscheidung einer SiGe-Mischhalbleiterschicht mit einem in situ-Konzentrationsgradienten, durch Überlagerung mit einem zweiten Konzentrationsgradienten ausgeglichen werden.

Auf ein Silizium-Halbleitersubstrat 10 wurde zunächst eine Schicht eines Dielektrikums 20 aufgebracht, wie in Figur 2a dargestellt ist. Das Dielektrikum ist vorzugsweise ausgebildet aus Siliziumoxid. Auf die Schicht des Dielektrikums 20 wurde eine SiGe-Mischhalbleiterschicht 30 abgeschieden, beispielsweise durch CVD-Verfahren, die einen in-situ-Konzentrationsgradienten von Germanium aufwies, wobei in dem oberen, zu oxidierenden, Schichtbereich 30b, eine geringere Germaniumkonzentration vorlag als in dem unteren, dem Siliziumsubstrat näher liegenden, Schichtbereich 30a, wie in Figur 2a gezeigt ist.

In einem folgenden Verfahrensschritt, der in Figur 2b dargestellt ist, wurde der durch die Abscheidung der SiGe-Mischhalbleiterschicht in situ ausgebildete Konzentrationsgradient durch thermische Oxidation, dargestellt durch wellenförmige Pfeile, ausgeglichen, wobei die thermische Oxidation einen zweiten Konzentrationsgradienten von Germanium erzeugte, der den bestehenden ausgleicht oder aufhebt. Durch die thermische Oxidation wurde auf der SiGe-Mischhalbleiterschicht ein thermisches Oxid 40 gewachsen, das vorzugsweise aus Siliziumoxid ausgebildet ist. Von Vorteil ist hierbei, dass durch die Diffusion von Germanium während der thermischen Oxidation das Germaniumkonzentrationsgefälle in der SiGe-Mischhalbleiterschicht 30a, 30b ausgeglichen wird, wobei vorteilhafter Weise zudem ein thermisches Oxid 40 erzeugt wird. Von Vorteil bei einer thermischen Oxidation einerSiGe-Mischhalbleiterschicht mit vorhandenem Konzentrationsgradienten ist, dass der oberflächennahe Schichtbereich 30b, an welchem die thermische Oxidation stattfindet, weniger Germanium enthält und daher bei der Oxidation eine Ge-freie Oxidschicht (aufgrund der Reduktion von Ge-Oxid an Si-Atomen) auch bei Temperaturen erhalten werden kann, die niedriger liegen können, als bei einer thermischen Oxidation von SiGe-Mischhalbleiterschichten erforderlich sind, die einen höheren Germaniumanteil aufweisen. Beispielsweise kann eine thermische Oxidation einer SiGe-Mischhalbleiterschicht 30a, 30b bei Temperaturen im Bereich von ≥ 800°C bis ≤ 900°C erfolgen. Die Schichtdicke des thermischen Oxids 40 liegt vorzugsweise im Bereich von 10 nm bis 100 nm.

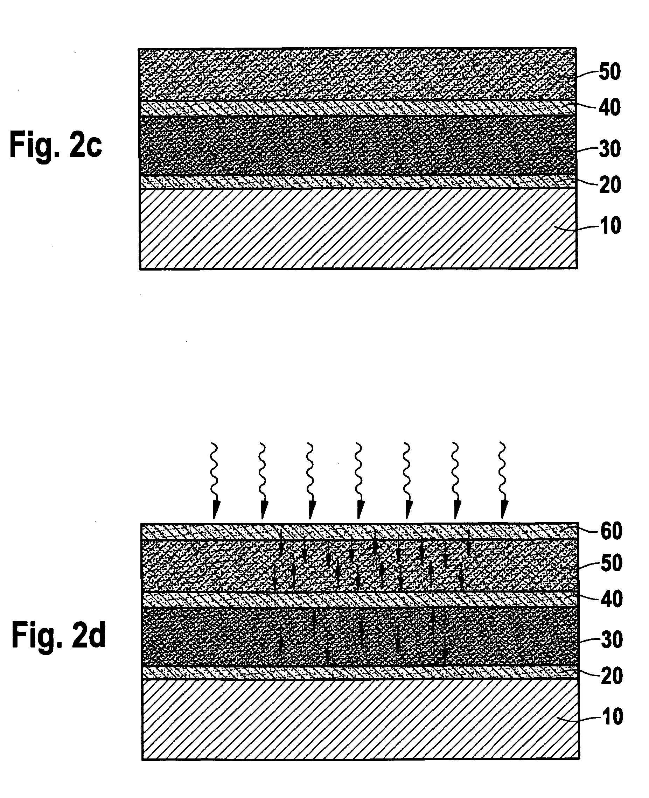

Auf die SiGe-Mischhalbleiterschicht 30 mit ausgeglichenem Germaniumanteil und das thermische Oxid 40 wurde in einem nachfolgenden Prozessschritt eine weitere SiGe-Mischhalbleiterschicht 50 aufgebracht, wie in Figur 2c dargestellt ist. Diese SiGe-Mischhalbleiterschicht 50 wies eine einheitliche Germaniumkonzentration über die Dicke der Schicht auf, die vorzugsweise im Bereich von x ≥ 0,03 bis ≤ 0,4 liegt.

Wie in Figur 2d dargestellt, wurde die SiGe-Mischhalbleiterschicht 50 anschließend einer weiteren thermischen Oxidation unterworfen. Weist die SiGe-Mischhalbleiterschicht 50 über ihre gesamte Dicke einen geringen Germaniumgehalt auf, kann der Anstieg der Germaniumkonzentration während der thermischen Oxidation in den oberen nm vernachlässigbar sein. Durch die thermische Oxidation wurde eine weitere Schicht eines thermischen Oxids 60 erzeugt.

Von Vorteil bei dem in den Figuren 2a bis 2d dargestellten Verfahren ist insbesondere, dass durch die thermischen Oxidationen thermische Siliziumoxidschichten 40 und 60 erzeugt werden können, die Schichten mit vergleichbaren Eigenschaften bilden.

Von besonderem Vorteil ist dabei, dass die thermischen Oxidationen einen symmetrischen Einschluss der SiGe-Mischhalbleiterschicht 50 mit gleichartigen stabilen thermischen Oxiden ermöglicht, die unter vergleichbaren Bedingungen durch thermische Oxidationen erzeugt wurden. Die SiGe-Mischhalbleiterschichten 30 und 50 weisen eine unterschiedliche Germaniumkonzentration auf, wobei die Konzentration der SiGe-Schicht 30 höher ist als die der SiGe-Schicht 50.

Bei einem nachfolgenden trockenchemischen Ätzen unter Verwendung des Ätzgases ClF₃ kann eine Selektivität des Ätzprozesses zwischen den beiden SiGe-Mischhalbleiterschichten 30 und 50 bei gleichen Ätzparametern erzeugt werden. Hierbei sollte die Germaniumkonzentration einer so genannten Opferschicht, die in größerem Ausmaß oder vollständig durch trockenchemische Ätzprozesse entfernt werden soll, höher liegen als die der weiteren SiGe-Schicht.

Bei einem trockenchemischen Ätzen des Schichtaufbaus wie in Figur 2d dargestellt, wird die SiGe-Mischhalbleiterschicht 30 entsprechend wesentlich schneller weggeätzt als die SiGe-Mischhalbleiterschicht 50. Von besonderem Vorteil ist hierbei, dass diese mikromechanischen Strukturen in einem einzigen trockenchemischen Ätzprozess ausgebildet werden können.

Hierbei sind die beiden SiGe-Mischhalbleiterschichten 30 und 50 durch das thermisch gewachsene Oxid 40 getrennt. Eine solche Struktur ist insbesondere von Vorteil im Fall der Herstellung von Membranen, beispielsweise in kapazitiven Drucksensoren und Mikrofonen. Die SiGe-Mischhalbleiterschicht ist in bevorzugten Ausführungsformen eine Si₁₋ₓGeₓ-Mischhalbleiterschicht mit einem Germaniumanteil mit x im Bereich von ≥ 0,01 bis ≤ 0,05.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Bevorzugte Ausgestaltungen des erfindungsgemäßen Verfahrens sind mit den nachgeordneten Patentansprüchen beansprucht und werden nachfolgend näher erläutert.

Der Germaniumanteil in der SiGe-Mischhalbleiterschicht ist variierbar. Beispielsweise sind durch Abscheidung einer SiGe-Schicht mittels CVD-Verfahren (CVD, "chemical vapour deposition") variable Anteile an Germanium innerhalb einer SiGe-Schicht einstellbar, der insbesondere über die Dicke der Schicht variiert werden kann. Beispielsweise ist bei einer Abscheidung einer SiGe-Mischhalbleiterschicht mittels CVD-Verfahren unter Verwendung von Silan und German der Anteil von Silan und German variierbar, wodurch der Germaniumanteil in der abgeschiedenen Schicht einstellbar ist. Dies ermöglicht die Herstellung einer SiGe-Schicht, die über die Dicke der Schicht wechselnde Anteile von Germanium aufweisen kann. Beispielsweise kann eine SiGe-Schicht über die Dicke der Schicht einen oder mehrere Bereiche mit erhöhtem Germaniumanteil aufweisen. Diese Bereiche mit erhöhtem Germaniumanteil werden bei einem nachfolgenden trockenchemischen Ätzschritt verstärkt herausgeätzt, wodurch Ausnehmungen in diesen Bereichen der SiGe-Schicht gegenüber den Bereichen mit geringerem Anteil an Germanium entstehen können. Dies ermöglicht die Herstellung von mikromechanischen Strukturen mit reliefartigem Scitenwandverlauf. Der Begriff "reliefartig" hat im Sinne der vorliegenden Erfindung die Bedeutung, dass ein Seitenwandverlauf insbesondere über die Dicke der Schicht Ausnehmungen oder vorstehende Bereiche aufweist.

Weiterhin ist ein sich stetig ändernder Anteil von Germanium oder Konzentrationsgradient über die Dicke einer SiGe-Mischhalbleiterschicht einstellbar, beispielsweise durch thermische Oxidation einer SiGe-Mischhalbleiterschicht.

Vorzugsweise ist in einer SiGe-Mischhalbleiterschicht zur Herstellung von mikromechanischen Strukturen mit konischem Seitenwandverlauf ein Konzentrationsgradient von Germanium ausbildbar. In bevorzugten Ausführungsformen kann der Gradient des Germaniumanteils in einer SiGe-Mischhalbleiterschicht kontinuierlich oder stufenweise variierend ausgebildet sein. Ein stufenweise ausgebildeter Gradient ist beispielsweise durch Abscheidung einer SiGe-Schicht ausbildbar, wobei bei der SiGe-Abscheidung eine stufenweise Variation des Konzentrationsgradienten beispielsweise durch Erhöhen des Germananteils, in situ ausbildbar ist.

Eine Variation des Germaniumanteils ist beispielsweise durch Abscheiden einer SiGc-Mischhalbleiterschicht mit über die Dicke der Schicht variierendem Germaniumgehalt, insbesondere durch Verfahren ausgewählt aus der Gruppe umfassend Abscheiden einer SiGe-Mischhalbleiterschicht insbesondere durch CVD-Verfahren, Einbringen von Germanium in eine Silizium-Halbleiterschicht oder SiGe-Mischhalbleiterschicht, Einbringen von Silizium in eine Germaniumschicht oder SiGe-Mischhalbleiterschicht und/oder durch thermische Oxidation einer SiGe-Mischhalbleiterschicht einstellbar.

Es kann vorgesehen sein, dass eine Kombination der Verfahren verwendbar ist.

Der Begriff "einstellbar" hat im Sinne der vorliegenden Erfindung insbesondere die Bedeutung, dass eine Variation ausbildbar oder beeinflussbar ist.

Beispielsweise sind variierende Germaniumanteile oder Germaniumgradienten in SiGe-Schichten mittels gerampter CVD-Verfahren leicht und reproduzierbar einstellbar. Von besonderem Vorteil ist hierbei, dass bei der Abscheidung der SiGe-Schichten sowohl anals auch absteigende Konzentrationen von Germanium herstellbar sind.

Bei einer thermischen Oxidation einer SiGe-Mischhalbleiterschicht wird ein Konzentrationsgradient des Germaniums eingestellt, indem eine gerichtete Diffusion des Germaniums unter Ausbildung eines Gradienten erfolgt.

Vorteilhaft ist insbesondere ein stetiger oder kontinuierlicher Gradient ohne Diskontinuitäten. Dies kann den Vorteil zur Verfügung stellen, dass der hergestellte konische Seitenwandverlauf ebenfalls einen kontinuierlichen Verlauf ohne Diskontinuitäten aufweisen kann.

In bevorzugten Ausführungsformen bildet man zur Herstellung von mikromechanischen Strukturen mit konischem Seitenwandverlauf einen über die Dicke der Schicht verlaufenden Gradienten des Germaniumanteils in der SiGe-Mischhalbleiterschicht aus.

Der ausgebildete Gradient in der SiGe-Mischhalbleiterschicht wirkt sich vorzugsweise direkt auf die Ätzrate des trockenchemischen Ätzens aus. Hierbei ist der Neigungswinkel des geätzten konischen Seitenwandverlaufs über die Wahl der SiGe-Schichtzusammensetzung einstellbar. Beispielsweise kann der Neigungswinkel im Bereich von > 0° bis ≤ 90° liegen. Ein ausgeprägter Gradient der Germaniumkonzentration kann beispielsweise einen flachen Neigungswinkel der geätzten Seitenwand erzeugen.

Ein weiterer besonderer Vorteil der Ausbildung eines Konzentrationsgradienten liegt darin, dass hierdurch die Eigenschaften der Schicht, beispielsweise eine Einstellung von mechanischen Spannungszuständen oder elektrische Eigenschaften für die jeweilige Anwendung eines mikromechanischen Bauteils optimiert werden kann.

In anderen Ausführungsformen des erfindungsgemäßen Verfahrens kann ein beispielsweise in situ abgeschiedener Gradient der Germaniumkonzentration beispielsweise durch eine thermische Oxidation durch einen zweiten Konzentrationsgradienten aufgehoben oder ausgeglichen werden. Eine Oxidation einer SiGe-Schicht, bei der ein ursprünglich vorliegender Konzentrationsgradient durch Überlagerung mit einem zweiten Konzentrationsgradienten aufgehobenen wird, kann zu einem Ausgleich der des Germaniumanteils in der Schicht und bei einem nachfolgenden trockenchemischen Ätzen der SiGe-Schicht zur Ausbildung eines vertikalen Seitenwandverlaufs führen.

Ein solches Verfahren ist insbesondere dann von Vorteil, wenn zu Beginn der thermischen Oxidation eine geringere Germaniumkonzentration in dem zu oxidierenden Bereich der SiGe-Schicht gefordert ist, beispielsweise um ein Oxid hoher Reinheit zu erhalten, in dieser Schicht jedoch eine Wand mit vertikalem Verlauf herauszuätzen ist, wozu eine homogene Zusammensetzung der SiGe-Schicht erforderlich ist. Von Vorteil ist hierbei, dass der oberflächennahe Schichtbereich auf dessen Oberfläche durch die thermische Oxidation ein thermisches Oxid ausgebildet wird, weniger Germanium enthält und somit bei niedrigeren Temperaturen zu einem Ge-freien Oxid oxidiert werden kann als eine SiGe-Schicht mit höherem Germaniumgehalt.

Ein besonders bevorzugtes Verfahren zur Einstellung eines Konzentrationsgradienten ist die thermische Oxidation einer SiGe-Mischhalbleiterschicht. Während der thermischen Oxidation bildet sich an der Oberfläche der SiGe-Schicht ein thermisches Oxid. Während der thermischen Oxidation wird Germanium von dem gebildeten thermischen Oxid ausgeschlossen und diffundiert in die SiGe-Schicht hinein. Hierbei wird ein Konzentrationsgradient in der Silizium-Germanium-Schicht ausgebildet, wobei durch die Diffusion des Germaniums höhere Germaniumkonzentrationen in Bereichen der Schicht nahe dem gebildeten Oxid ausgebildet werden und aufgrund der Diffusionswege des Germaniums der ausgebildete Germaniumgradient in Richtung der Tiefe der Schicht abnimmt.

Die Ätzrate von SiGe steigt mit zunehmendem Germaniumanteil in der Schicht an. In einem nachfolgenden trockenchemischen Ätzen erfolgt ein stärkerer Abtrag der SiGe-Schicht in dem der gebildeten Oxidschicht näher liegenden Bereich, der eine höhere Germaniumkonzentration aufweist, als in tiefer liegenden Bereichen, die geringere Germaniumkonzentrationen aufweisen. Hierdurch wird ein konischer Seitenwandverlauf ausgebildet.

Das durch den thermischen Oxidationsprozess nicht in das ausgebildete thermische Oxid eingebaute Germanium diffundiert in die unterhalb des Oxids liegende SiGe-Schicht. Bei Temperaturen, die keine ausreichende Diffusion des Germaniums in der SiGe-Schicht ermöglichen, kann sich ein so genannter Germanium-pile-up an der Grenzschicht des ausgebildeten thermischen Oxids zu der SiGe-Schicht bilden. Liegen die Temperaturen während des thermischen Oxidationsverfahrens hoch genug, um die Diffusion des Germaniums zu aktivieren, diffundiert das Germanium tiefer in die SiGe-Schicht hinein.

In bevorzugten Ausführungsformen liegt die Temperatur, bei der die thermische Oxidation der SiGe-Mischhalbleiterschicht durchgeführt wird, in einem Bereich von ≥ 800°C bis ≤ 1300°C. Bevorzugt ist, dass die thermische Oxidation bei Temperaturen im Bereich von ≥ 900°C bis ≤ 1200°C ausgeführt wird. Es ist besonders bevorzugt, dass die thermische Oxidation bei Temperaturen im Bereich von ≥ 1000°C bis ≤ 1100°C ausgeführt wird.

Eine thermische Oxidation zur Herstellung mikromechanischer Strukturen mit vertikalem Seitenwandverlauf durch Aufhebung eines bestehenden Konzentrationsgradienten durch Überlagerung mit einem zweiten durch thermische Oxidation kann bei Temperaturen in einem Bereich von beispielsweise ≥ 800°C bis≤ 900°C durchgeführt werden. Es versteht sich von selbst, dass ein solcher Ausgleich eines vorhandenen Konzentrationsgradienten durch einen zweiten Konzentrationsgradienten ebenfalls durch Einbringen von Germanium in Silizium oder Silizium-Germaniumschichten oder Einbringen von Silizium in Germanium oder SiGe-Schichten ausbildbar ist.

Eine weitere bevorzugte Möglichkeit ist das Einbringen von Germanium oder Silizium mittels Verfahren der Dotierung oder der Implantation. Ein Vorteil von Dotier- und Implantationsverfahren liegt insbesondere darin, dass hierbei lokale Gradienten einstellbar sind. Dies kann die Möglichkeit zur Verfügung stellen, in einer zu ätzenden SiGe-Schicht verschiedene Gradienten zur Verfügung stellen zu können.

Die Dotierung kann grundsätzlich durch jeden aus der Halbleitertechnik bekannten Dotierungsprozess erfolgen, bevorzugt sind Dotierungen aus der Gasphase. Insbesondere kann Germanium durch Einbringen in auf Silizium basierende Schichten, insbesondere SiGe-Mischhalbleiter, durch Implantationsverfahren erfolgen. Das Einbringen von Germanium oder Silizium erfolgt vorzugsweise durch Implantation von Germaniumionen oder Siliziumionen, die vorzugsweise aus einer geeigneten Ionenquelle erzeugbar sind. Von besonderem Vorteil ist hierbei, dass beispielsweise mittels eines fokussierten Germaniumionenstrahls zu ätzende Bereiche einer Silizium- oder SiGe-Schicht selektiv abgefahren und mit Germanium angereichert werden können. Dies erlaubt ein äußerst selektives Einbringen von Germanium an den zu ätzenden Bereichen der Silizium- oder SiGe-Schicht. Von Vorteil ist hier insbesondere, dass lokale Gradienten ausbildbar sind.

Verfahren der Einbringung von Germanium oder Silizium in zu ätzende Schichten sind bevorzugt, wenn Germanium in eine Siliziumschicht oder Silizium in eine Germaniumschicht eingebracht werden soll. Es ist ebenso möglich, Germanium in eine SiGe-Mischhalbleiterschicht einzubringen. Ebenfalls ist es bevorzugt, in eine reine Germaniumschicht oder ein auf Germanium basierendes Substrat Silizium zu implantieren. In diesem Fall würden Bereiche, die nicht entfernt werden sollen, mit Silizium dotiert.

Der Gehalt an Silizium und Germaniums in einer SiGe-Mischhalbleiterschicht kann je nach Bedarf variieren. Vorzugsweise ist eine SiGe-Mischhalbleiterschicht eine Si₁₋ₓGeₓ-Mischhalbleiterschicht. Vorteilhafter Weise liegt der Wert für x in einer Si₁₋ₓGeₓ-Schicht unterhalb von 0,5. Eine solche Zusammensetzung einer SiGe-Mischhalbleiterschicht kann den Vorteil zur Verfügung stellen, dass beispielsweise bei einer thermischen Oxidation des Silizium-Germaniums bevorzugt reines Siliziumdioxid auf der SiGe-Mischhalbleiterschicht entsteht. Ein höherer Anteil von Germanium in einer SiGc-Mischhalbleiterschicht kann dazu führen, dass anstelle von reinem Siliziumoxid Germanium-Siliziumoxid-Mischoxide entstehen können. Es ist von besonderem Vorteil wenn durch eine thermische Oxidation reines Siliziumoxid ausgebildet werden kann, da eine solche Schicht eine Diffusionsbarriere zwischen der darunter liegenden SiGe-Mischhalbleiterschicht und möglichen weiteren auf dem Oxid abgeschiedenen auf Silizium basierenden Schichten zur Verfügung stellen kann.

Vorzugsweise liegt der Germaniumanteil in einer Si₁₋ₓGeₓ-Mischhalbteiterschicht bei einem Wert für x im Bereich von ≥ 0,01 bis < 1, bevorzugt im Bereich von ≥ 0,01 bis ≤ 0,6, weiter bevorzugt im Bereich von ≥ 0,1 bis ≤ 0,4. In bevorzugten Ausführungsformen liegt der Germaniumanteil in einer Si₁₋ₓGeₓ-Mischhalbleiterschicht bei einem Wert für x im Bereich von ≥ 0,01 bis < 0,5, vorzugsweise im Bereich von ≥ 0,03 bis ≤ 0,4, bevorzugt im Bereich von ≥ 0,05 bis ≤ 0,3, besonders bevorzugt im Bereich von ≥ 0,1 bis ≤ 0,2. Diese Bereiche können den Vorteil zur Verfügung stellen, dass ein kontrollierter, insbesondere in der Ätzgeschwindigkeit steuerbarer und gleichzeitig gegenüber Silizium und Siliziumoxid hochselektiver Ätzvorgang zur Verfügung gestellt werden kann. Beispielsweise kann die Selektivität des trockenchemischen Ätzens einer solchen Si₁₋ₓGeₓ-Schicht gegenüber Silizium im Bereich von etwa 4.000:1 bis 10.000:1 liegen und gegenüber Siliziumoxid sogar etwa 100.000:1 betragen. Dies ermöglicht, dass mikromechanische Strukturen mit reliefartigem Seitenwandverlauf oder einstellbarem Neigungswinkel aus SiGe-Mischhalbleiterschichten herausgeätzt werden können, während weitere auf einem Siliziumsubstrat vorhandene auf Silizium basierende Schichten durch den Ätzvorgang nicht betroffen und insbesondere nicht zerstört werden.

Es ist insbesondere bei Verfahren der thermischen Oxidation vorteilhaft, dass x < 0,5 ist, so dass der Germaniumanteil in der SiGe-Mischhalbleiterschicht weniger als 50% beträgt. Dies kann den Vorteil zur Verfügung stellen, dass ein auf einer solchen Schicht aufgewachsenes thermisches Oxid kein Germanium enthält, da durch die thermische Oxidation gegebenenfalls gebildeten Germaniumoxide durch den Siliziumüberschuss an der Grenzschicht Silizium-Germanium zu Oxid durch das Silizium reduziert werden, wobei Siliziumdioxid gebildet wird. In vorteilhafter Weise ist unter diesen Bedingungen ein Siliziumoxid erhältlich, das weitestgehend frei von Germaniumoxid ist.

Dies kann den Vorteil zur Verfügung stellen, dass eine Diffusion von Germanium durch reinere Siliziumoxidschichten besser vermindert oder sogar verhindert werden kann als durch Schichten die Germaniumoxid enthalten würden. Die Funktionalität des thermischen Oxids als Diffusionsbarriere zwischen einer SiGe-Mischhalbleiterschicht und anderen benachbarten auf Silizium basierenden Schichten kann somit verbessert werden.

Ein durch die thermische Oxidation einer SiGe-Mischhalbleiterschicht ausgebildetes thermisches Oxid kann den Vorteil zur Verfügung stellen, dass dieses als Dielektrikum, Diffusionsbarriere oder als Schutzschicht für nachfolgende Verfahrensschritte bei der Herstellung mikromechanischer Bauteile bei Bedarf als Schicht in einem Schichtensystem bestehen bleiben kann.

Die Dicke der Oxidschicht kann variieren. Ein besonderer Vorteil eines durch die thermische Oxidation einer SiGe-Mischhalbleiterschicht gebildeten Oxids kann dadurch zu Verfügung gestellt werden, dass dieses in der Mikrosystemtechnik insbesondere als Dielektrikum verwendbar ist. Insbesondere ist von Vorteil, dass wenn die thermische Oxidation in bereits vorstrukturiertem Silizium-Germanium ausgeführt wird, die ausgebildete dielektrische Schicht nicht in einem weiteren Verfahrensschritt erneut strukturiert werden muss. Von Vorteil ist hierbei insbesondere, dass selbst wenn auf der Oberfläche eines Siliziumsubstrats neben den zu oxidierenden Silizium-Germaniumstrukturen weitere Siliziumstrukturen vorhanden sind, die Oxidationsrate von Silizium-Germanium im Vergleich zu Silizium mehr als doppelt so hoch liegt. Somit können Silizium-Germaniumbereiche hochselektiv im Gegensatz zu reinem Silizium oxidiert werden. Für eine weitere Verwendung als Dielektrikum liegt die Dicke der Schicht des thermischen Oxids vorzugsweise im Bereich von einigen Mikrometern, beispielsweise im Bereich von 1 µm bis 3 µm.

Weiterhin ist die durch die thermische Oxidation erzeugte Oxidschicht als Diffusionsbarriere zwischen der zumeist als Opferschicht verwendbaren SiGe-Schicht und darüber oder darunter liegenden funktionellen Siliziumschichten verwendbar. Dies stellt insbesondere den Vorteil zur Verfügung, dass nicht auf qualitativ weniger geeignete Oxide zurück gegriffen werden muss, die beispielsweise mittel PECVD-Verfahren ("plasma enhanced chemical vapour deposition") aufgebracht werden müssen. Eine durch thermische Oxidation erzeugbare reine Siliziumoxidschicht kann das Ausdiffundieren von Germanium in benachbarte auf Silizium basierende Schichten in vorteilhafter Weise vermindern oder sogar verhindern. Eine Notwendigkeit Diffusionsbarrieren für Germanium zwischen SiGe-Opferschichten und Siliziumschichten einzubauen, besteht insbesondere in den Fällen, in denen nach einer Abscheidung einer SiGe-Schicht auf dem Siliziumsubstrat weitere Hochtemperaturschritte vorgesehen sind, die durch die hohe Temperatur eine weitere Diffusion von Germanium hervorrufen. Die Dicke einer solchen Diffusionsbarriere liegt vorzugsweise im Bereich von 10 nm bis 100 nm.

Bevorzugte Verfahren des trockenchemischen Ätzens sind plasmalose trockenchemische Ätzverfahren. Bevorzugt verwendbare Ätzmittel für das trockenchemische Ätzen sind ausgewählt aus der Gruppe umfassend ClF₃, ClF₅ und/oder BrF₃. Ein ganz besonders bevorzugtes Ätzgas ist ClF₃. Insbesondere konnte festgestellt werden, dass ein plasmaloses Ätzen mit ClF₃ Ätzraten aufweist, die nahezu unabhängig von der Schichtdicke sind. Dies stellt den Vorteil zur Verfügung, dass die Dicke von zu ätzenden Opferschichten keinen negativen Einfluss auf das Ätzen dieser Opferschichten zeigt.

In bevorzugten Ausführungsformen führt man das trockenchemische Ätzen der SiGe-Mischhalbleiterschicht bei einer Temperatur des Si-Halbleitersubstrats und/oder der SiGe-Mischhalbleiterschicht im Bereich von ≥ -30°C bis ≤ 60°C durch, vorzugsweise im Bereich von ≥ -20°C bis ≤ 40°C, bevorzugt im Bereich von ≥ -10°C bis ≤ 10°C. Von Vorteil ist, dass unter diesen Bedingungen eine SiGe-Schicht selektiv gegenüber Silizium und gegenüber dielektrischen, auf Silizium basierenden Schichten beispielsweise Siliziumoxid oder Siliziumoxinitrid, geätzt werden kann, ohne dass es zu deren Passivierung weiterer Schutzmaßnahmen bedarf.

Weiterhin ist bevorzugt, dass man das trockenchemische Ätzen der SiGe-Mischhalbleiterschicht bei einem Druck im Bereich von ≥ 0,1 Pa bis ≤ 1000 Pa, vorzugsweise im Bereich von ≥ 8 Pa bis ≤ 400 Pa, bevorzugt in einem Bereich von ≥ 10 Pa bis ≤ 100 Pa durchführt.

Ein weiterer Gegenstand der Erfindung betrifft mikromechanische Strukturen mit reliefartigem Seitenwandverlauf oder einstellbarem Neigungswinkel hergestellt gemäß dem erfindungsgemäßen Verfahren.

Die gemäß dem erfindungsgemäßen Verfahren herstellbaren mikromechanischen Silizium-Germaniumstrukturen eignen sich insbesondere als Opferschicht. Vorteilhafter Weise können auf die Silizium-Germaniumstrukturen weitere Schichtsysteme abgeschieden werden, auf die sich der in der Silizium-Germaniumschicht einstellbare beispielsweise konische Seitenwandverlauf überträgt. Dies ermöglicht beispielsweise eine Verwendung bei der Herstellung von Membranen ohne ebene Einspannung. Beispielsweise ermöglichen Silizium-Germaniumstrukturen mit konischem Seitenwandverlauf eine nachfolgende Abscheidung von Membranschichten mit abgeflachtem Einspannwinkel. Membranen mikromechanischer Bauteile sind beispielsweise Teil von mikromechanischen Sensorelementen.

Weiterhin ermöglicht eine Ausbildung eines Konzentrationsgradienten beispielsweise von Germanium durch Implantation, dass mehrere Ätzbereiche nebeneinander herstellbar sind wobei die Implantation auf diese Bereiche beschränkt wird. Dies ermöglicht beispielsweise eine Anwendung des erfindungsgemäßen Verfahrens zur Herstellung von Mikronadeln.

Weiterhin sind gemäß dem erfindungsgemäßen Verfahren herstellbare mikromechanische Strukturen mit reliefartigem Seitenwandverlauf oder einstellbarem Neigungswinkel, insbesondere vertikale oder konische Seitenwandverläufe, vorteilhaft verwendbar vor der Abscheidung von Schichten, bei denen es wegen ihrer verhältnismäßig schlechten Konformität Probleme bei vertikal zu beschichtenden Stufen geben kann, beispielsweise bei PECVD-Prozessen, Sputterprozessen oder bei besonders dünnen Schichten. Weiterhin bieten mikromechanischen Sensoren vorteilhafte Anwendungsmöglichkeiten des Verfahrens und der erfindungsgemäß herstellbaren mikromechanischen Strukturen mit reliefartigem Seitenwandverlauf oder einstellbarem Neigungswinkel.

## Patentansprüche

1. Verfahren zur Herstellung von mikromechanischen Strukturen mit reliefartigem Seitenwandverlauf oder einstellbarem Neigungswinkel, wobei man die mikromechanischen Strukturen aus einer auf einem Silizium-Halbleitersubstrat (1, 10) vorhandenen oder abgeschiedenen SiGe-Mischhalbleiterschicht (3a, 3b, 30, 30a, 30b, 50) durch trockenchemisches Ätzen der SiGe-Mischhalbleiterschicht (3a, 3b, 30, 30a, 30b, 50) herausätzt, wobei man den Seitenwandverlauf der mikromechanischen Struktur durch Variieren des Germaniumanteils in der zu ätzenden SiGe-Mischhalbleiterschicht (3a, 3b, 30, 30a, 30b, 50) ausbildet, wobei in stärker zu ätzenden Bereichen ein höherer Germaniumanteil vorliegt, wobei man die Variation des Germaniumanteils in der SiGe-Mischhalbleiterschicht (3a, 3b, 30, 30a, 30b, 50) durch ein Verfahren ausgewählt aus der Gruppe umfassend Abscheiden einer SiGe-Mischhalbleiterschicht (3a, 3b, 30, 30a, 30b, 50) mit variierendem Germaniumgehalt, Einbringen von Germanium in eine Silizium-Halbleiterschicht oder SiGe-Mischhalbleiterschicht (3a, 3b, 30, 30a, 30b, 50), Einbringen von Silizium in eine Germaniumschicht oder SiGe-Mischhalbleiterschicht (3a, 3b, 30, 30a, 30b, 50) und/oder durch thermische Oxidation einer SiGe-Mischhalbleiterschicht (3a, 3b, 30, 30a, 30b, 50) einstellt.

2. Verfahren nach Anspruch 1, **dadurch gekennzeichnet, dass** man einen kontinuierlich oder stufenweise variierenden Gradienten des Germaniumanteils in der SiGe-Mischhalbleiterschicht (3a, 3b, 30, 30a, 30b, 50) ausbildet.

3. Verfahren nach Anspruch 1 oder 2, **dadurch gekennzeichnet, dass** man zur Herstellung von mikromechanischen Strukturen mit konischem Seitenwandverlauf einen über die Dicke der Schicht verlaufenden Gradienten des Germaniumanteils in der SiGe-Mischhalbleiterschicht (3a, 3b, 30, 30a, 30b, 50) ausbildet.

4. Verfahren nach einem der vorherigen Ansprüche, **dadurch gekennzeichnet, dass** man Germanium oder Silizium mittels Verfahren der Dotierung oder Implantation einbringt.

5. Verfahren nach einem der vorherigen Ansprüche, **dadurch gekennzeichnet, dass** man die thermische Oxidation der SiGe-Mischhalbleiterschicht (3a, 3b, 30, 30a, 30b, 50) bei einer Temperatur im Bereich von ≥ 800°C bis ≤ 1300°C, vorzugsweise im Bereich von ≥ 900°C bis ≤ 1200°C, bevorzugt im Bereich von ≥ 1000°C bis ≤ 1100°C, durchführt.

6. Verfahren nach einem der vorherigen Ansprüche, **dadurch gekennzeichnet, dass** die SiGe-Mischhalbleiterschicht (3a, 3b, 30, 30a, 30b, 50) eine S₁₋ₓ-Geₓ-Mischhalbleiterschicht mit einem Germanium-Anteil mit x im Bereich von ≥ 0,01 bis < 1, bevorzugt im Bereich von ≥ 0,01 bis < 0,5, vorzugsweise im Bereich von ≥ 0,03 bis ≤ 0,4, besonders bevorzugt im Bereich von ≥ 0,05 bis ≤ 0,3, ganz besonders bevorzugt im Bereich von ≥ 0,1 bis ≤ 0,2, ist.

7. Verfahren nach einem der vorherigen Ansprüche, **dadurch gekennzeichnet, dass** man das trockenchemische Ätzen der SiGe-Mischhalbleiterschicht (3a, 3b, 30, 30a, 30b, 50) mittels eines Ätzgases ausgewählt aus der Gruppe umfassend ClF₃, ClF₅ und/oder BrF₃ durchführt.

8. Verfahren nach einem der vorherigen Ansprüche, **dadurch gekennzeichnet, dass** man das trockenchemische Ätzen der SiGe-Mischhalbleiterschicht (3a, 3b, 30, 30a, 30b, 50) bei einer Temperatur des Silizium-Halbleitersubstrats (1, 10) und/oder der SiGe-Mischhalbleiterschicht (3a, 3b, 30, 30a, 30b, 50) im Bereich von ≥ -30°C bis ≤ 60°C, vorzugsweise im Bereich von ≥ -20°C bis ≤ 40°C, bevorzugt im Bereich von ≥ -10°C bis ≤ 10°C, durchführt.

9. Verfahren nach einem der vorherigen Ansprüche, **dadurch gekennzeichnet, dass** man das trockenchemische Ätzen der SiGe-Mischhalbleiterschicht (3a, 3b, 30, 30a, 30b, 50) bei einem Druck im Bereich von ≥ 0,1 Pa bis ≤ 1000 Pa, vorzugsweise im Bereich von ≥ 8 Pa bis ≤ 400 Pa, bevorzugt im Bereich von ≥ 10 Pa bis ≤ 100 Pa, durchführt.

10. Mikromechanische Strukturen mit reliefartigem Seitenwandverlauf oder einstellbarem Neigungswinkel hergestellt gemäß dem Verfahren nach einem der vorherigen Ansprüche.

## Claims

1. Method for producing micromechanical structures having a relief-like side wall profile or an adjustable angle of inclination, wherein the micromechanical structures are etched from an SiGe mixed semiconductor layer (3a, 3b, 30, 30a, 30b, 50) present or deposited on a silicon semiconductor substrate (1, 10), by means of the dry-chemical etching of the SiGe mixed semiconductor layer (3a, 3b, 30, 30a, 30b, 50), wherein the side wall profile of the micromechanical structure is formed by the variation of the germanium proportion in the SiGe mixed semiconductor layer (3a, 3b, 30, 30a, 30b, 50) to be etched, wherein a higher germanium proportion is present in regions that are to be etched to a greater extent, wherein the variation of the germanium proportion in the SiGe mixed semiconductor layer (3a, 3b, 30, 30a, 30b, 50) is established by a method selected from the group comprising deposition of an SiGe mixed semiconductor layer (3a, 3b, 30, 30a, 30b, 50) having a varying germanium content, introduction of germanium into a silicon semiconductor layer or SiGe mixed semiconductor layer (3a, 3b, 30, 30a, 30b, 50), the introduction of silicon into a germanium layer or SiGe mixed semiconductor layer (3a, 3b, 30, 30a, 30b, 50) and/or by thermal oxidation of an SiGe mixed semiconductor layer (3a, 3b, 30, 30a, 30b, 50).

2. Method according to Claim 1, **characterized in that** a gradient of the germanium proportion in the SiGe mixed semiconductor layer (3a, 3b, 30, 30a, 30b, 50) is formed, which gradient varies continuously or in a stepwise manner.

3. Method according to Claim 1 or 2, **characterized in that**, in order to produce micromechanical structures having a conical side wall profile, a gradient of the germanium proportion in the SiGe mixed semiconductor layer (3a, 3b, 30, 30a, 30b, 50) is formed, which gradient extends over the thickness of the layer.

4. Method according to any of the preceding claims, **characterized in that** germanium or silicon is introduced by means of methods of doping or implantation.

5. Method according to any of the preceding claims, **characterized in that** the thermal oxidation of the SiGe mixed semiconductor layer (3a, 3b, 30, 30a, 30b, 50) is carried out at a temperature in the range of ≥ 800°C to ≤ 1300°C, preferably in the range of ≥ 900°C to ≤ 1200°C, preferably in the range of ≥ 1000°C to ≤ 1100°C.

6. Method according to any of the preceding claims, **characterized in that** the SiGe mixed semiconductor layer (3a, 3b, 30, 30a, 30b, 50) is an Si₁₋ₓGeₓ mixed semiconductor layer having a germanium proportion with x in the range of ≥ 0.01 to < 1, preferably in the range of ≥ 0.01 to < 0.5, preferably in the range of ≥ 0.03 to ≤ 0.4, particularly preferably in the range of ≥ 0.05 to ≤ 0.03, especially preferably in the range of ≥ 0.1 to ≤ 0.2.

7. Method according to any of the preceding claims, **characterized in that** the dry-chemical etching of the SiGe mixed semiconductor layer (3a, 3b, 30, 30a, 30b, 50) is carried out by means of an etching gas selected from the group comprising ClF₃, ClF₅ and/or BrF₃.

8. Method according to any of the preceding claims, **characterized in that** the dry-chemical etching of the SiGe mixed semiconductor layer (3a, 3b, 30, 30a, 30b, 50) is carried out at temperature of the silicon semiconductor substrate (1, 10) and/or of the SiGe mixed semiconductor layer (3a, 3b, 30, 30a, 30b, 50) in the range ≥ -30°C to ≤ 60°C, preferably in the range of ≥ -20°C to ≤ 40°C, preferably in the range of ≥ -10°C to ≤ 10°C.

9. Method according to any of the preceding claims, **characterized in that** the dry-chemical etching of the SiGe mixed semiconductor layer (3a, 3b, 30, 30a, 30b, 50) is carried out at a pressure in the range of ≥ 0.1 Pa to ≤ 1000 Pa, preferably in the range of ≥ 8 Pa to ≤ 400 Pa, preferably in the range of ≥ 10 Pa to ≤ 100 Pa.

10. Micromechanical structures having a relief-like side wall profile or an adjustable angle of inclination, produced in accordance with the method according to any of the preceding claims.

## Revendications

1. Procédé de fabrication de structures micromécaniques dont les parois latérales présentent une évolution en relief ou un angle d'inclinaison ajustable, dans lequel on grave les structures micromécaniques dans une couche semi-conductrice mixte (3a, 3b, 30, 30a, 30b, 50) de SiGe présente ou déposée sur un substrat semi-conducteur (1, 10) en silicium, par gravure chimique à sec de la couche semi-conductrice mixte (3a, 3b, 30, 30a, 30b, 50) de SiGe, en formant l'évolution de la paroi latérale de la structure micromécanique par modification de la teneur en germanium de la couche semi-conductrice mixte (3a, 3b, 30, 30a, 30b, 50) de SiGe à graver, une plus forte teneur en germanium étant présente dans les parties qui doivent être gravées davantage, la variation de la teneur en germanium de la couche semi-conductrice mixte (3a, 3b, 30, 30a, 30b, 50) de SiGe étant réalisée par un procédé sélectionné dans l'ensemble comportant le dépôt d'une couche semi-conductrice mixte (3a, 3b, 30, 30a, 30b, 50) de SiGe à teneur en germanium variable, l'apport de germanium dans une couche semi-conductrice de silicium ou dans une couche semi-conductrice mixte (3a, 3b, 30, 30a, 30b, 50) de SiGe, l'apport de silicium dans une couche de germanium ou dans une couche semi-conductrice mixte (3a, 3b, 30, 30a, 30b, 50) de SiGe et/ou l'oxydation thermique d'une couche semi-conductrice mixte (3a, 3b, 30, 30a, 30b, 50) de SiGe.

2. Procédé selon la revendication 1, **caractérisé en ce que** l'on forme des gradients variant de manière progressive ou par gradin de la teneur en germanium dans la couche semi-conductrice mixte (3a, 3b, 30, 30a, 30b, 50) de SiGe.

3. Procédé selon les revendications 1 ou 2, **caractérisé en ce que** pour réaliser des structures micromécaniques dont les parois latérales évoluent coniquement, on forme dans la couche semi-conductrice mixte (3a, 3b, 30, 30a, 30b, 50) de SiGe un gradient de teneur en germanium qui s'étend sur l'épaisseur de la couche.

4. Procédé selon l'une des revendications précédentes, **caractérisé en ce que** l'on apporte du germanium ou du silicium au moyen d'un procédé de dopage ou d'implantation.

5. Procédé selon l'une des revendications précédentes, **caractérisé en ce que** l'on réalise l'oxydation thermique de la couche semi-conductrice mixte (3a, 3b, 30, 30a, 30b, 50) de SiGe à une température comprise dans la plage de ≥ 800°C à ≤ 1 300°C, mieux dans la plage de ≥ 900°C à ≤ 1 200°C et de préférence dans la plage de ≥ 1 000°C à ≤ 1 100°C.

6. Procédé selon l'une des revendications précédentes, **caractérisé en ce que** la couche semi-conductrice mixte (3a, 3b, 30, 30a, 30b, 50) de SiGe est une couche semi-conductrice mixte de Si₁₋ₓGeₓ dont la teneur en germanium, x, est comprise dans la plage de ≥ 0,01 à < 1, de préférence dans la plage de ≥ 0,01 à < 0,5, mieux dans la plage de ≥ 0,03 à ≤ 0,4, de façon particulièrement préférable dans la plage de ≥ 0,05 à ≤ 0,3 et de façon tout particulièrement préférable dans la plage de ≥ 0,1 à ≤ 0,2.

7. Procédé selon l'une des revendications précédentes, **caractérisé en ce que** l'on effectue la gravure chimique à sec de la couche semi-conductrice mixte (3a, 3b, 30, 30a, 30b, 50) de SiGe au moyen d'un gaz de gravure sélectionné dans l'ensemble comprenant ClF₃, ClF₅ et/ou BrF₃.

8. Procédé selon l'une des revendications précédentes, **caractérisé en ce que** l'on effectue la gravure chimique à sec de la couche semi-conductrice mixte (3a, 3b, 30, 30a, 30b, 50) de SiGe à une température du substrat semi-conducteur (1, 10) de silicium et/ou de la couche semi-conductrice mixte (3a, 3b, 30, 30a, 30b, 50) de SiGe comprise dans la plage de ≥ -30°C à ≤ 60°C, mieux dans la plage de ≥ -20°C à ≤ 40°C et de préférence dans la plage de ≥ -10°C à ≤ 10°C.

9. Procédé selon l'une des revendications précédentes, **caractérisé en ce que** l'on effectue la gravure chimique à sec de la couche semi-conductrice mixte (3a, 3b, 30, 30a, 30b, 50) de SiGe à une pression comprise dans la plage de ≥ 0,1 Pa à ≤ 1 000 Pa, de préférence dans la plage de ≥ 8 Pa à ≤ 400 Pa et mieux dans la plage de ≥ 10 Pa à ≤ 100 Pa.

10. Structures micromécaniques dont les parois latérales évoluent en relief ou dont l'angle d'inclinaison est ajustable, réalisées par le procédé selon l'une des revendications précédentes.
